# EUROPÄISCHE PATENTSCHRIFT

(11) **EP 3 243 914 B1**
(45) Veröffentlichungstag und Bekanntmachung des Hinweises auf die Patenterteilung: **17.10.2018**
(21) Anmeldenummer: 16169646.3
(22) Anmeldetag: 13.05.2016
(51) Int. Cl.: C22B 3/00, C23C 14/34

(54) **VERFAHREN ZUR HERSTELLUNG VON PARTIKULÄREM RUTHENIUM**
METHOD OF MANUFACTURING PARTICULATE RUTHENIUM
PROCEDE DE PRODUCTION DE RUTHENIUM PARTICULAIRE

(43) Veröffentlichungstag der Anmeldung: 15.11.2017
(73) Patentinhaber: Heraeus Deutschland GmbH & Co. KG, 63450 Hanau (DE)
(72) Erfinder: THIEL, Vasco, 63755 Alzenau (DE); STEMMLER, Marco, 63776 Mömbris (DE); VON EIFF, Hermann, 63453 Neuberg (DE); KRAUSHAAR, Christian, 63517 Rodenbach (DE); RÖDER, Jan, 63579 Freigericht (DE); RÖHLICH, Christoph, 63456 Hanau (DE)
(74) Vertreter: Heraeus IP

(56) Entgegenhaltungen:
- EP-A1- 2 236 633
- EP-A2- 1 950 178
- JP-A- 2000 178 721
- US-A- 6 036 741

## Beschreibung

Die Erfindung betrifft ein Verfahren zur Herstellung von partikulärem Ruthenium.

Die Herstellung von Ruthenium durch Kalzinieren von Ammoniumchlororuthenat-Verbindungen ist bekannt, beispielsweise aus EP 2 090 669 A2, EP 2 096 084 A1,
EP 2 236 633 A1 und DE 42 06 156 C1. Beispiele für Reaktionsgleichungen, die den Prozess der Rutheniumbildung beschreiben können, sind:

2(NH₄)₃RuCl₆ → 2Ru + N₂ + 4NH₄Cl + 8HCl

3(NH₄)₂RuCl₆ → 3Ru + 2N₂ + 2NH₄Cl + 16HCl

3(NH₄)₄[Ru₂Cl₁₀O] → 6Ru + 4N₂ + 4NH₄Cl + 26HCl + 3H₂O

6(NH₄)₂RuCl₅OH → 6Ru + 4N₂ + 4NH₄Cl + 26HCl + 6H₂O

JP 2000 178721 A offenbart zur Herstellung von Ruthenium-Sputtertargets verwendbares Rutheniumpulver mit einer Reinheit des Rutheniums von ≥ 99,998%.

EP 1 950 178 A2 offenbart die Herstellung von Ammoniumhexachlororuthenat durch Zugabe von Ammoniumchlorid zu einer Ruthenium enthaltenden salzsauren Lösung. Das Ammoniumhexachlororuthenat wird durch Glühen zu Rutheniumpulver umgewandelt.

Die Anmelderin hat festgestellt, dass partikuläres Ruthenium mit einer Reinheit von ≥ 99,99 Gew.-% und einer spezifischen Oberfläche von 0,2 bis 0,5 m²/g besonders geeignet ist zur Herstellung von Ruthenium-Targets, insbesondere nach dem Sparkplasmasintering-Verfahren. Die Anmelderin hat ferner ein Verfahren gefunden mittels dessen derartiges partikuläres Ruthenium hergestellt werden kann.

Die Erfindung betrifft ein Verfahren zur Herstellung partikulären Rutheniums mit einer Reinheit von ≥ 99,99 Gew.-% und einer spezifischen Oberfläche von 0,2 bis 0,5 m²/g, bevorzugt 0,22 bis 0,35 m²/g. Das Verfahren umfasst die Schritte:
(1) Bereitstellen einer durch Aufnehmen von RuO₄ in Salzsäure hergestellten salzsauren Lösung mit einem Gehalt von als gelöste Rutheniumspezies vorliegendem Ruthenium im Bereich von 15 bis 22 Gew.-%,
(2) Bereitstellen einer wässrigen Lösung mit einem Gehalt von Ammoniumchlorid im Bereich von 200 bis 600 g/Liter, bevorzugt 200 bis 500 g/Liter, insbesondere 200 bis 400 g/Liter,
(3) Bilden einer Reaktionsmischung durch Zudosieren der in Schritt (1) bereitgestellten salzsauren Lösung zur in Schritt (2) bereitgestellten wässrigen Lösung in einem Mol-Verhältnis von 1 Mol Ruthenium : 3 bis 6 Mol Ammoniumchlorid, bevorzugt von 1 Mol Ruthenium : 4,5 bis 6 Mol Ammoniumchlorid, bei einer Temperatur von 55 bis 90 °C, bevorzugt 65 bis 85 °C, innerhalb von 0,2 bis 5 Stunden, bevorzugt 1 bis 5 Stunden, insbesondere
   1 bis 3 Stunden, und unter Einstellung und Einhaltung eines pH-Wertes im Bereich von - 0,6 bis 0,
(4) Abtrennen von während Schritt (3) gebildetem Feststoff aus der salzsauren Reaktionsmischung, und
(5) Kalzinieren des in Schritt (4) abgetrennten Feststoffs bei einer Objekttemperatur im Bereich von 350 bis 1000 °C, bevorzugt 450 bis 900 °C.

Hierin wird der Ausdruck "Spezifische Oberfläche" verwendet. Die spezifische Oberfläche in m²/g kann mittels BET-Messung gemäß DIN ISO 9277 : 2014-01
(gemäß Kapitel 6.3.1, statisch-volumetrisches Messverfahren, verwendetes Gas: Stickstoff) bestimmt werden.

In Schritt (1) des erfindungsgemäßen Verfahrens wird eine durch Aufnehmen von RuO₄ in Salzsäure hergestellte salzsaure Lösung mit einem Gehalt von als gelöste Rutheniumspezies vorliegendem Ruthenium im Bereich von 15 bis 22 Gew.-% bereitgestellt. Beispiele für in diesem Zusammenhang zu nennende gelöste Rutheniumspezies sind insbesondere Rutheniumchlorid und Hexachlororutheniumsäure. Die Vorgehensweise des Aufnehmens von RuO₄ in Salzsäure ist dem Fachmann beispielsweise aus EP 2 090 669 A2, EP 2 096 084 A1 und EP 2 236 633 A1 bekannt. Zweckmäßigerweise wird 5- bis 12-molare Salzsäure zur Aufnahme des RuO₄ verwendet.

Die in Schritt (1) bereitgestellte salzsaure Lösung kann einen pH-Wert beispielsweise im Bereich von -0,9 bis -0,7 haben.

In Schritt (2) des erfindungsgemäßen Verfahrens wird eine wässrige Lösung mit einem Gehalt von Ammoniumchlorid im Bereich von 200 bis 600 g/Liter, bevorzugt 200 bis 500 g/Liter, insbesondere 200 bis 400 g/Liter bereitgestellt. Insbesondere handelt es sich dabei um eine wässrige Lösung von Ammoniumchlorid, speziell eine Lösung von Ammoniumchlorid in Wasser ohne Zusatz oder Anwesenheit weiterer Substanzen in der wässrigen Lösung. Die Herstellung einer solchen wässrigen Lösung birgt für den Fachmann keinerlei Schwierigkeiten, so dass sich eine weitere Erläuterung erübrigt.

In Schritt (3) des erfindungsgemäßen Verfahrens wird eine Reaktionsmischung gebildet, indem die in Schritt (1) bereitgestellte salzsaure Lösung zur in Schritt (2) bereitgestellten wässrigen Lösung in einem Mol-Verhältnis von 1 Mol Ruthenium : 3 bis 6 Mol Ammoniumchlorid, bevorzugt von 1 Mol Ruthenium : 4,5 bis 6 Mol Ammoniumchlorid, bei einer Temperatur von 55 bis 90 °C, bevorzugt 65 bis 85 °C, innerhalb von 0,2 bis 5 Stunden, bevorzugt 1 bis 5 Stunden, insbesondere 1 bis 3 Stunden, und unter Einstellung und Einhaltung eines pH-Wertes der Reaktionsmischung im Bereich von -0,6 bis 0 zudosiert wird.

Die in den Schritten (1) und (2) bereitgestellten Lösungen werden in Schritt (3) zu einer Reaktionsmischung vereinigt, indem die in Schritt (1) bereitgestellte Lösung zur in Schritt (2) bereitgestellten Lösung zudosiert wird und nicht etwa umgekehrt. Während des Zudosierens wird zweckmäßigerweise gerührt.

Das Zudosieren erfolgt in einem Mol-Verhältnis von 1 Mol Ruthenium : 3 bis 6 Mol Ammoniumchlorid, bevorzugt von 1 Mol Ruthenium : 4,5 bis 6 Mol Ammoniumchlorid, d.h. die in den Schritten (1) und (2) bereitgestellten Lösungen werden im Verhältnis 1 Mol Ruthenium : 3 bis 6 Mol Ammoniumchlorid, bevorzugt im Verhältnis 1 Mol Ruthenium : 4,5 bis 6 Mol Ammoniumchlorid zur Reaktionsmischung vereinigt.

Während Schritt (3) wird die Temperatur im Bereich von 55 bis 90 °C, bevorzugt 65 bis 85 °C eingestellt und gehalten. Mit anderen Worten, die Temperatur der Reaktionsmischung wird von Beginn bis Ende des Zudosierens der in Schritt (1) bereitgestellten Lösung zur in Schritt (2) bereitgestellten Lösung im Bereich von 55 bis 90 °C, bevorzugt 65 bis 85 °C eingestellt und gehalten.

Während Schritt (3) wird ein pH-Wert der Reaktionsmischung im Bereich von -0,6 bis 0 eingestellt und gehalten. Bei Beginn des Zudosierens liegt der pH-Wert der entstehenden Reaktionsmischung üblicherweise oberhalb von 0 und fällt dann schnell mit fortschreitendem Zudosieren der in Schritt (1) bereitgestellten salzsauren Lösung. Der pH-Wert kann aber auch mittels Salzsäure von Anbeginn des Zudosierens auf einen pH-Wert im Bereich von -0,6 bis 0 eingestellt sein. Während des Zudosierens kann die Einstellung und Einhaltung des pH-Wertes im Bereich von -0,6 bis 0 durch Zugeben einer entsprechenden Menge an Salzsäure geeigneter Konzentration unterstützt werden.

Das Zudosieren in Schritt (3) geschieht innerhalb von 0,2 bis 5 Stunden, bevorzugt 1 bis 5 Stunden, insbesondere 1 bis 3 Stunden.

Während Schritt (3) kommt es zur Ausfällung eines Feststoffs aus der salzsauren Reaktionsmischung.

Es kann zweckmäßig sein, die nach Beendigung des Zudosierens entstandene Reaktionsmischung anschließend noch nachzurühren, beispielsweise für einen Zeitraum von 30 bis 60 Minuten.

In Schritt (4) des erfindungsgemäßen Verfahrens wird der in Schritt (3) gebildete Feststoff aus der salzsauren Reaktionsmischung abgetrennt. Dabei können übliche dem Fachmann bekannte Fest-Flüssig-Trennverfahren eingesetzt werden, beispielsweise Dekantieren, Abhebern, Abfiltrieren oder geeignete Kombinationen solcher Trennverfahren.

In Schritt (5) des erfindungsgemäßen Verfahrens wird der in Schritt (4) abgetrennte Feststoff bei einer Objekttemperatur (Temperatur des zu kalzinierenden Materials) von 350 bis 1000 °C, insbesondere 450 bis 900 °C kalziniert, beispielsweise für eine Zeitdauer von mindestens 1,5 Stunden, insbesondere 1,5 bis 7 Stunden.

Das Kalzinieren kann an der Luft, unter Inertgasatmosphäre, beispielsweise unter Stickstoff und/oder Argon, oder in reduzierender Atmosphäre, beispielsweise unter Stickstoff/Wasserstoff im Volumenverhältnis 90 : 10 bis 95 : 5 erfolgen.

Zweckmäßigerweise werden die gasförmigen Zersetzungsprodukte des Kalzinierungsprozesses mittels eines Gasstromes (Strom aus besagter Luft, Inertgas oder reduzierendem Gasgemisch) aus dem Kalzinierungsofen abgeführt.

Das metallische Ruthenium bleibt zurück in partikulärer Form mit einer spezifischen Oberfläche von 0,2 bis 0,5 m²/g, bevorzugt 0,22 bis 0,35 m²/g.

Die Reinheit des erhaltenen Rutheniums kann ≥ 99,99 Gew.-% betragen; insbesondere ist dies üblicherweise der Fall, wenn die Kalzinierung unter Ausschluss von Luftzutritt, d.h. unter Inertgasatmosphäre oder in reduzierender Atmosphäre erfolgt ist.

Insbesondere falls das Kalzinieren gemäß Schritt (5) an der Luft stattgefunden hat, d.h. unter Zutritt von Luftsauerstoff, aber auch anderenfalls kann es zweckmäßig sein, einen Schritt (6) in Form einer üblichen dem Fachmann bekannten Reduktionsbehandlung des erhaltenen partikulären Rutheniums durchzuführen. Beispielsweise kann der Reinheitsgrad damit auf ≥ 99,99 Gew.-% gebracht werden. Geeignet als Reduktionsbehandlung ist beispielsweise eine Behandlung mit Wasserstoff bei erhöhten Temperaturen im Bereich von beispielsweise 120 bis 900 °C. Der optionale Schritt (6) hat üblicherweise keinen Einfluss auf die spezifische Oberfläche des nach Abschluss von Schritt (5) erhaltenen partikulären Rutheniums.

Der mittlere Partikeldurchmesser d50 des nach Abschluss von Schritt (5) oder (6) erhaltenen partikulären Rutheniums, genauer gesagt, der mittlere Partikeldurchmesser d50 der Primärteilchen des partikulären Rutheniums, kann im Bereich von beispielsweise 5 bis 50 µm liegen. Der d50-Wert kann mittels Laserdiffraktometrie, beispielsweise mit einem Lasergranulometer (z.B. CILAS 920 der Firma Quantachrome, Odelzhausen, Deutschland) bestimmt werden.

### Beispiele

Das die Schritte (1) bis (5) umfassende erfindungsgemäße Verfahren wurde im Labor mehrfach unter Variation verschiedener Parameter durchgeführt. Außerdem wurden Vergleichsversuche außerhalb des erfindungsgemäßen Rahmens durchgeführt.

Ausgehend von dem gemäß Beispiel 1 der EP 2 236 633 A1 hergestellten Material wurde Schritt (1) des Verfahrens gemäß dem in den Abschnitten [18] - [27] der EP 2 096 084 A1 offenbarten Beispiel durchgeführt. Variiert wurde der Rutheniumgehalt.

In Schritt (2) wurden wässrige Ammoniumchlorid-Lösungen verschiedener Konzentration hergestellt.

In Schritt (3) wurde jeweils mit einem 1 : 5,4-Molverhältnis von Ruthenium : Ammoniumchlorid gearbeitet bei einer Ansatzgröße von 150 bis 400 mL. Variiert wurden pH-Wert und Temperatur der Reaktionsmischung sowie Zugabedauer der in Schritt (1) bereitgestellten Lösung.

In Schritt (5) wurde 2 Stunden bei 800° C Objekttemperatur unter Stickstoffstrom kalziniert.

Erhalten wurde jeweils partikuläres Ruthenium mit einer Reinheit von ≥ 99,99 Gew.-% und einem mittleren Partikeldurchmesser d50 im Bereich von 15 bis 45 µm.
Nachfolgende Tabelle zeigt die in den verschiedenen Beispielen (1-18 erfindungsgemäß, 19-21 Vergleich) angewendeten Parameter sowie die für das jeweils erhaltene partikuläre Ruthenium mit der vorerwähnten Methode ermittelte spezifische Oberfläche.

| Beispiel | Ru-Gehalt (Gew.-%) | NH₄Cl-Gehalt (g/L) | pH | T (°C) | Zugabedauer (h) | BET (m²/g) |
|---|---|---|---|---|---|---|
| 1 | 15 | 200 | -0,6 | 55 | 0,2 | 0,41 |
| 2 | 22 | 600 | 0 | 55 | 3 | 0,27 |
| 3 | 15 | 200 | -0,6 | 90 | 3 | 0,27 |
| 4 | 15 | 600 | -0,6 | 90 | 0,2 | 0,40 |
| 5 | 22 | 200 | 0 | 55 | 0,2 | 0,44 |
| 6 | 22 | 200 | -0,6 | 55 | 3 | 0,43 |
| 7 | 22 | 600 | -0,6 | 55 | 0,2 | 0,33 |
| 8 | 15 | 200 | 0 | 55 | 3 | 0,30 |
| 9 | 15 | 200 | 0 | 90 | 0,2 | 0,32 |
| 10 | 22 | 600 | 0 | 90 | 0,2 | 0,43 |
| 11 | 22 | 200 | -0,6 | 90 | 0,2 | 0,43 |
| 12 | 15 | 600 | -0,6 | 55 | 3 | 0,23 |
| 13 | 18,5 | 400 | -0,2 | 72,5 | 1,6 | 0,33 |
| 14 | 15 | 600 | 0 | 55 | 0,2 | 0,23 |
| 15 | 22 | 200 | 0 | 90 | 3 | 0,27 |
| 16 | 22 | 600 | -0,6 | 90 | 3 | 0,44 |
| 17 | 18,5 | 400 | -0,2 | 72,5 | 1,6 | 0,28 |
| 18 | 15 | 600 | 0 | 90 | 3 | 0,28 |
| 19 (Vgl.) | 25 | 190 | -0,6 | 50 | 0,2 | 0,61 |
| 20 (Vgl.) | 12 | 180 | 0 | 90 | 3 | 0,18 |
| 21 (Vgl.) | 15 | 600 | 0,3 | 55 | 4 | 0,16 |

## Patentansprüche

1. Verfahren zur Herstellung partikulären Rutheniums mit einer Reinheit von ≥ 99,99 Gew.-% und einer spezifischen Oberfläche von 0,2 bis 0,5 m²/g, umfassend die Schritte:
(1) Bereitstellen einer durch Aufnehmen von RuO₄ in Salzsäure hergestellten salzsauren Lösung mit einem Gehalt von als gelöste Rutheniumspezies vorliegendem Ruthenium im Bereich von 15 bis 22 Gew.-%,
(2) Bereitstellen einer wässrigen Lösung mit einem Gehalt von Ammoniumchlorid im Bereich von 200 bis 600 g/Liter,
(3) Bilden einer Reaktionsmischung durch Zudosieren der in Schritt (1) bereitgestellten salzsauren Lösung zur in Schritt (2) bereitgestellten wässrigen Lösung in einem Mol-Verhältnis von 1 Mol Ruthenium : 3 bis 6 Mol Ammoniumchlorid bei einer Temperatur von 55 bis 90 °C innerhalb von 0,2 bis 5 Stunden und unter Einstellung und Einhaltung eines pH-Wertes im Bereich von -0,6 bis 0,
(4) Abtrennen von während Schritt (3) gebildetem Feststoff aus der salzsauren Reaktionsmischung, und
(5) Kalzinieren des in Schritt (4) abgetrennten Feststoffs bei einer Objekttemperatur im Bereich von 350 bis 1000 °C.

2. Verfahren nach Anspruch 1, wobei die in Schritt (1) bereitgestellte salzsaure Lösung einen pH-Wert im Bereich von -0,9 bis -0,7 hat.

3. Verfahren nach Anspruch 1 oder 2, wobei es sich bei der in Schritt (2) bereitgestellten wässrigen Lösung um eine wässrige Lösung von Ammoniumchlorid handelt.

4. Verfahren nach einem der vorhergehenden Ansprüche, wobei die Temperatur in Schritt (3) 65 bis 85 °C beträgt.

5. Verfahren nach einem der vorhergehenden Ansprüche, wobei die Zudosierdauer in Schritt (3) 1 bis 5 Stunden beträgt.

6. Verfahren nach einem der vorhergehenden Ansprüche, wobei das Mol-Verhältnis 1 Mol Ruthenium : 4,5 bis 6 Mol Ammoniumchlorid beträgt.

7. Verfahren nach einem der vorhergehenden Ansprüche, wobei das Kalzinieren bei einer Objekttemperatur von 450 bis 900 °C erfolgt.

8. Verfahren nach einem der vorhergehenden Ansprüche, wobei die Zeitdauer des Kalzinierens 1,5 bis 7 Stunden beträgt.

9. Verfahren nach einem der vorhergehenden Ansprüche, wobei das Kalzinieren an der Luft, unter Inertgasatmosphäre oder in reduzierender Atmosphäre stattfindet.

10. Verfahren nach einem der vorhergehenden Ansprüche, umfassend einen Schritt (6), in dem das erhaltene partikuläre Ruthenium einer Reduktionsbehandlung unterworfen wird.

11. Verfahren nach Anspruch 10, wobei die Reduktionsbehandlung in einer Behandlung mit Wasserstoff bei Temperaturen im Bereich von 120 bis 900 °C besteht.

## Claims

1. A method for producing particulate ruthenium having a purity of ≥99.99 per cent by weight and a specific surface of 0.2 to 0.5 m²/g, comprising the steps of:
(1) providing a hydrochloric solution produced by RuO₄ being received in hydrochloric acid, the solution having a content of ruthenium within a range from 15 to 22 per cent by weight, the ruthenium being present as dissolved ruthenium species,
(2) providing an aqueous solution having a content of ammonium chloride within a range from 200 to 600 g/litre,
(3) forming a reaction mixture by adding the hydrochloric solution provided in step (1) to the aqueous solution provided in step (2) at a mol ratio of 1 mol of ruthenium : 3 to 6 mols of ammonium chloride at a temperature of 55 to 90 °C within 0.2 to 5 hours, with a pH value being adjusted and maintained within a range from -0.6 to 0,
(4) separating solids formed in step (3) from the hydrochloric reaction mixture, and
(5) calcining the solids separated in step (4) at an object temperature within a range from 350 to 1000 °C.

2. The method in accordance with Claim 1, wherein the hydrochloric solution provided in step (1) has a pH value within a range from - 0.9 to - 0.7.

3. The method in accordance with Claim 1 or 2, wherein the aqueous solution provided in step (2) is an aqueous solution of ammonium chloride.

4. The method in accordance with any one of the preceding claims, wherein the temperature in step (3) is 65 to 85 °C.

5. The method in accordance with any one of the preceding claims, wherein the adding time in step (3) is 1 to 5 hours.

6. The method in accordance with any one of the preceding claims, wherein the mol ratio is 1 mol of ruthenium : 4.5 to 6 mols of ammonium chloride.

7. The method in accordance with any one of the preceding claims, wherein the calcining step is performed at an object temperature of 450 to 900 °C.

8. The method in accordance with any one of the preceding claims, wherein the calcining time is 1.5 to 7 hours.

9. The method in accordance with any one of the preceding claims, wherein the calcining step is performed in the air, in an inert gas atmosphere or in a reducing atmosphere.

10. The method in accordance with any one of the preceding claims, comprising a step (6) in which the obtained particulate ruthenium is subjected to a reduction treatment.

11. The method in accordance with Claim 10, wherein the reduction treatment consists of a treatment with hydrogen at temperatures within a range from 120 to 900 °C.

## Revendications

1. Procédé pour la fabrication de ruthénium particulaire avec une pureté de ≥ 99,99 % en poids et une surface spécifique de 0,2 à 0,5 m²/g, comprenant les étapes suivantes :
(1) Préparation d'une solution chlorhydrique produite par l'absorption de RuO₄ dans l'acide chlorhydrique, avec une teneur en ruthénium présente comme sorte de ruthénium dissous dans la gamme de 15 à 22 % en poids,
(2) Préparation d'une solution aqueuse avec une teneur en chlorure d'ammonium dans la gamme de 200 à 600 g/litre,
(3) Formation d'un mélange de réaction par un ajout dosé de la solution chlorhydrique préparée dans l'étape (1) dans la solution aqueuse préparée dans l'étape (2) dans un rapport molaire de 1 mole de ruthénium : 3 à 6 moles de chlorure d'ammonium à une température de 55 à 90°C en l'espace de 0,2 à 5 heures et en régulant et en observant une valeur de pH dans la gamme de -0,6 à 0,
(4) Séparation de la matière solide formée pendant l'étape (3) à partir du mélange de réaction chlorhydrique et
(5) Calcination de la matière solide séparée dans l'étape (1) à une température d'objet dans la gamme de 350 à 1000 °C.

2. Procédé conformément à la revendication n°1, la solution chlorhydrique préparée dans l'étape (1) présentant une valeur de pH dans la gamme de -0,9 à -0,7.

3. Procédé conformément à la revendication n°1 ou n°2, la solution aqueuse préparée dans l'étape (2) étant une solution aqueuse de chlorure d'ammonium.

4. Procédé conformément à l'une des revendications précédentes, la température dans l'étape (3) étant comprise entre 65 et 85 °C.

5. Procédé conformément à l'une des revendications précédentes, la durée d'ajout dosé dans l'étape (3) étant comprise entre 1 et 5 heures.

6. Procédé conformément à l'une des revendications précédentes, le rapport molaire étant de 1 mole de ruthénium : 4,5 à 6 moles de chlorure d'ammonium.

7. Procédé conformément à l'une des revendications précédentes, la calcination opérant à une température d'objet de 450 à 900 °C.

8. Procédé conformément à l'une des revendications précédentes, la durée de la calcination étant comprise entre 1,5 à 7 heures.

9. Procédé conformément à l'une des revendications précédentes, la calcination ayant lieu à l'air libre, dans une atmosphère de gaz inerte ou dans une atmosphère réductrice.

10. Procédé conformément à l'une des revendications précédentes, comprenant une étape (6), dans laquelle le ruthénium particulaire obtenu est soumis à un traitement de réduction.

11. Procédé conformément à la revendication n°10, le traitement de réduction consistant dans un traitement avec de l'hydrogène à des températures dans la gamme de 120 à 900 °C.
